# EUROPÄISCHE PATENTSCHRIFT

(11) **EP 1 148 634 B1**
(45) Veröffentlichungstag und Bekanntmachung des Hinweises auf die Patenterteilung: **04.10.2006**
(21) Anmeldenummer: 01100365.4
(22) Anmeldetag: 05.01.2001
(51) Int. Cl.: H03F 1/30

(54) **Verstärkerschaltung**
Amplifier circuit
Circuit amplificateur

(30) Priorität: 20.01.2000 DE 10002371
(43) Veröffentlichungstag der Anmeldung: 24.10.2001
(73) Patentinhaber: Infineon Technologies AG, 81669 München (DE)
(72) Erfinder: Weber, Stephan, 81739 München (DE); Lipperer, Georg, 81735 München (DE)
(74) Vertreter: Epping - Hermann - Fischer

(56) Entgegenhaltungen:
- DE-C- 19 742 954
- US-A- 5 854 578
- US-A- 5 986 508
- US-A- 5 986 509

## Beschreibung

Die Erfindung betrifft eine Hochfrequenz-Verstärkerschaltung mit Regelung durch Arbeitspunkteinstellung.

Elektronische Bauelemente und Baugruppen sind Schwankungen beziehungsweise Toleranzen unterworfen. Schwankungen der Technologieparameter in der Fertigung führen zu Toleranzen der Kennwerte von Bauelementen. Beispielsweise sind die Gleichstromverstärkung B und die Kleinsignalverstärkung β von Bipolartransistoren fertigungsbedingten Toleranzen unterworfen. Bei hohen Anforderungen an die Genauigkeit der Bauelemente müssen fertigungsbedingte Toleranzen durch aufwendige Abgleichmaßnahmen reduziert werden.

Baugruppen, welche aus toleranzbehafteten Bauelementen aufgebaut sind, unterliegen hierdurch selbst Schwankungen. Beispielsweise hängt die Kennlinie eines Leistungsverstärkers von der Kennlinie der internen Transistoren ab. Bei einem Verstärker, welcher aus Feldeffekt-Transistoren aufgebaut ist, hängt beispielsweise die Stellkennlinie des Leistungsverstärkers von der Schwellenspannung U_{TO} der Feldeffekttransistoren ab. Die Schwellenspannung U_{TO} der Feldeffekttransistoren ist ebenso wie ihre Steilheit von Fertigungstoleranzen abhängig. Bei kleinen Dimensionen hängt die Schwellenspannung beispielsweise von Kanallänge und Kanalweite des Feldeffekt-transistors ab.

Hochfrequenz-Leistungsverstärker finden beispielsweise als Sendeverstärker in Systemen Anwendung, die nach dem Zeitschlitz-Verfahren (Time Division Multiple Access, TDMA-Verfahren) arbeiten. Ein Beispiel für ein solches Zeitschlitz-Verfahren ist der Mobilfunkstandard GSM. Bei solchen Verfahren wird das Senden von Daten in sogenannte Zeitscheiben zerlegt. Damit in einem Ruhezustand des Hochfrequenz-Verstärkers die Ausgangsleistung desselben Null ist, muß ein den Verstärker regelnder Verstärker am Steuereingang des Hochfrequenz-Verstärkers eine Spannung unterhalb der Schwellenspannung des Verstärker-Transistors einstellen. Hierdurch wird aber die Charakteristik des Hochfrequenz-Verstärkers in nachteilhafter Weise beeinflusst. Von der Ruhespannung des Reglers, welche am Eingang des Verstärkers anliegt, bis zum Leistungseinsatz des Verstärkers zu Beginn eines SendeZeitschlitzes liegt eine tote Zone vor, welche die Regeleigenschaften des Systems verschlechtert.

Werden die Regeleigenschaften des Systems zu schlecht, so muß ein Abgleich vorgenommen werden. Bekannt ist, diesen Abgleich individuell vorzunehmen, beispielsweise mit einem Potentiometer, oder die Sollspannung des Reglers zu modifizieren, beispielsweise durch Überlagerung eines Offsets. Realisierungen dieser individuellen Abgleich-Möglichkeiten sind jedoch sehr aufwendig.

Ein Bedarf zum Abgleich bei der Regelung eines Leistungsverstärkers kann auch durch sich ändernde Umgebungsbediungungen, beispielsweise Temperatur, oder durch Änderung der Versorgungsspannung gegeben sein.

Das Dokument US 5,986,508 betrifft ein Bias-Konzept für eine intrinsische Stabilisierung der Verstärkung über der Temperatur. Es ist ein temperaturkompensierendes Steuerelement bei einem Verstärker mit aktiver Bias-Steuerung vorgesehen. Der Bias-Strom wird so beeinflusst, dass bei schwankender Temperatur die Bauteilverstärkung konstant gehalten wird.

Aufgabe der vorliegenden Erfindung ist es, eine Verstärkerschaltung mit Kompensation fertigungsbedingter Toleranzen anzugeben.

Erfindungsgemäß wird diese Aufgabe gelöst von einer Verstärkerschaltung gemäß Patentanspruch 1.

Als Leistungsverstärker ist ein erster Transistor angegeben, der an eine Versorgungsspannung anschließbar ist. Diesem Verstärker wird eingangsseitig ein zu verstärkendes Eingangssignal zugeführt, und ausgangsseitig ist als Ausgangssignal das verstärkte Eingangssignal abgreifbar. Dieser Leistungsverstärker wird von einem Regelverstärker geregelt. Der Regelverstärker weist einen Operationsverstärker auf, dessen Ausgang mit dem Eingang des ersten Transistors verbunden ist. Außerdem ist das am Verstärker abgreifbare Ausgangssignal an einen ersten Eingang des Operationsverstärkers zurückgeführt. Bezüglich dieser Regleranordnung stellt der Leistungsverstärker das Stellglied dar. Zur Bildung einer Referenzspannung ist ein zweiter Transistor in einer Referenzstufe vorgesehen, welcher mit dem Operationsverstärker zur Übermittlung eines Referenzspannungswertes verbunden ist. Dieser zweite Transistor ist ein physikalisches Abbild des ersten Transistors, so daß er zur Toleranzkompensation herangezogen werden kann. Erster und zweiter Transistor sind vom gleichen Transistor-Typ, der zweite Transistor ist jedoch gegenüber dem ersten Transistor skaliert. Der erste und der zweite Transistor weisen insbesondere gleiche elektrische Verhältnisse auf. An einem zweiten Eingang des Operationsverstärkers ist über ein Filter ein Soll-Signal des Reglers zuführbar, welches die gewünschte Ausgangsleistung des Leistungsverstärkers angibt. Der in der Referenzstufe angeordnete zweite Transistor bildet mit dem Regelverstärker eine Kompensationsschaltung für den Hochfrequenz-Leistungsverstärker, so daß die Regelung abgleichfrei arbeiten kann. Gegenüber einem einmaligen Abgleich weist die vorliegende Schaltung den zusätzlichen Vorteil auf, daß die Temperatur- und Betriebsspannungsabhängigkeit der Verstärkerschaltung von der Referenzstufe miterfaßt und automatisch kompensiert wird. Eine solche Temperaturänderung kann beispielsweise betriebsbedingt sein, oder durch äußere Einflüsse entstehen. Bei einem Einsatz der Schaltung als Sendeverstärker im Mobilfunkbereich hängt die Betriebsspannung beispielsweise vom Ladezustand eines Akkumulators des Mobilfunk-Gerätes ab.

In einer vorteilhaften Ausführungsform der vorliegenden Erfindung sind der Leistungsverstärker und die Referenzstufe auf dem gleichen Halbleiter-Baustein angeordnet. Hierdurch ist einerseits bei der Fertigung eine gute Paarung der Transistoren gewährleistet, so daß der erste und der zweite Transistor Kennwerte aufweisen, welche sich möglichst wenig unterscheiden, und andererseits wird durch die Anordnung auf dem gleichen Chip eine enge thermische Kopplung ermöglicht.

In einer weiteren, vorteilhaften Ausführungsform der vorliegenden Erfindung kann die Fertigungstoleranzen unterliegende Schwellenspannung des ersten Transistors dadurch vom Regelverstärker abgeglichen werden, daß der zweite Transistor, welcher in der Referenzstufe angeordnet ist, an seinem Source-Anschluß einen hochohmigen Widerstand gegen Masse aufweist, über dem praktisch die Schwellenspannung abfällt. Diese Referenzspannung wird über eine Verbindung zwischen Referenzstufe und Operationsverstärker zur Kompensation der Toleranzen der Schwellenspannung des ersten Transistors herangezogen.

Weitere Ausführungsformen und Ausgestaltungen der Erfindung sind in den Unteransprüchen angegeben.

Die Erfindung wird nachfolgend an einem Ausführungsbeispiel anhand der Zeichnungen näher erläutert.

Es zeigen:
- Figur 1: Ein Ausführungsbeispiel der vorliegenden Erfindung anhand eines vereinfachten Schaltbilds,
- Figur 2: Die Arbeitspunkt-Einstellung der Referenzstufe.

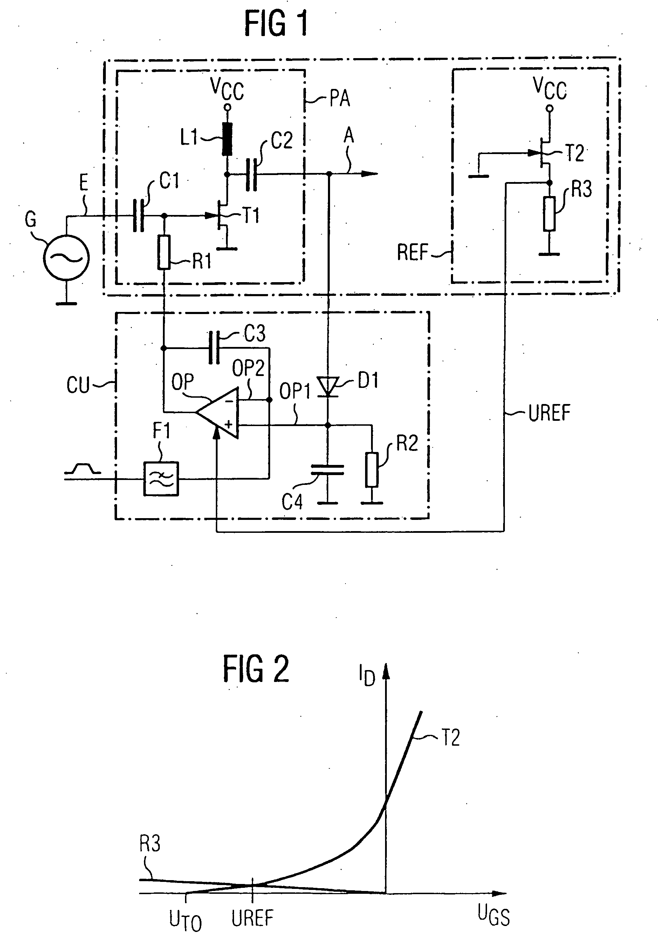

Figur 1 zeigt eine prinzipielle Schaltungsanordnung mit einem Hochfrequenz-Verstärker PA, wie er beispielsweise als Sende-Verstärker im Mobilfunkbereich eingesetzt wird. Der signalverstärkende Transistor T1 ist im vorliegenden Beispiel als Feldeffekt-Transistor ausgeführt. Über eine Spule L1 zur Hochfrequenz-Entkopplung ist dieser an eine Spannungsquelle V_{CC}anschließbar. An das Gate des Transistors ist zum einen, über einen ersten Kondensator C1 entkoppelt, ein zu verstärkendes Eingangssignal E zuführbar. Das verstärkte Signal ist am Ausgang des Transistors als Ausgangssignal A, wiederum über einen Kondensator C2 entkoppelt, abgreifbar und einem Verbraucher, beispielsweise einer Sendeantenne, zuführbar. Dem Steuereingang des Feldeffekt-Transistors T1 ist außerdem über einen Widerstand R1 ein Steuersignal zuführbar, welches der Leistungsvorgabe des Hochfrequenz-Verstärkers durch den Regler CU dient. Diese Leistungsvorgabe erfolgt im wesentlichen durch Einstellen des Arbeitspunkts des Feldeffekt-Transistors T1. Der Regelverstärker CU weist einen Operationsverstärker OP auf, an dessen Ausgang das Steuersignal für den Hochfrequenz-Verstärker PA abgreifbar ist. Dem Operationsverstärker OP ist ein Sollsignal zuführbar, welches die Leistungsvorgabe für den Hochfrequenz-Verstärker PA beinhaltet. Dieses Sollsignal ist im vorliegenden Beispiel dem Minus-Eingang OP2 des Operationsverstärkers OP zuführbar, an dem zusätzlich ein Rückkopplungszweig, welcher einen Integrier-Kondensator C3 aufweisen kann, anschließbar. An den Plus-Eingang OP1 des Operationsverstärkers OP ist das Ausgangssignal A des Hochfrequenz-Verstärkers PA über eine Diode D1 angeschlossen. Zwischen Diode D1 und Operationsverstärker-Eingang OP1 ist außerdem ein Kondensator C4 und parallel dazu ein Widerstand R2 zur Realisierung eines Tiefpasses gegen Masse geschaltet. Hierdurch wird das am Ausgang des Hochfrequenz-Verstärkers abgreifbare Leistungssignal in einen vom Operationsverstärker zu verarbeitenden Spannungswert umgesetzt. Zur Kompensation von Toleranzen im Transistor T1 ist eine Referenzstufe angeordnet, welche einen zweiten Transistor T2 aufweist. Diese Referenzstufe hat mit ihrem Transistor T2 ein physikalisches Abbild des Transistors T1. Der Transistor T2 weist den gleichen Typ wie Transistor T1 auf, ist aber skaliert. Insbesondere weist der Transistor T2 gleiche elektrische DC-Verhältnisse wie der Transistor T1 auf. Das vorliegende Ausführungsbeispiel dient der Kompensation von Toleranzen bezüglich der Schwellenspannung von Feldeffekt-Transistor T1. Dafür weist der Source-Anschluß des Referenztransistors T2 einen gegen Masse geschalteten Widerstand R3 auf, über dem, wenn der Widerstand R3 hochohmig gewählt wird, nahezu die Schwellenspannung U_{TO}abfällt. Diese Referenzspannung UREF wird über eine Leitung dem Operationsverstärker OP zugeführt und dort zum Abgleich der Toleranzen herangezogen.

Im vorliegenden Ausführungsbeispiel ist der Regler CU in Silizium realisiert, und Leistungsverstärker PA sowie Referenzstufe REF beide entweder in GaAs-Technologie oder in HBT(Hetero-Bipolar-Transistor)-Technologie.

Figur 2 zeigt die Übertragungskennlinie eines Feldeffekt-Transistors T2, nämlich den Drainstrom I_{D} als Funktion der Gate-Source-Spannung U_{GS}. Weiterhin ist die Widerstandskennlinie des Referenz-Widerstands R3 eingezeichnet. Der Schnittpunkt beider Kennlinien führt zur abgreifbaren Referenzspannung UREF. Man erkennt, daß die der Schaltung ableitbare Referenzspannung UREF umso genauer der Schwellenspannung U_{TO} des Feldeffekt-Transistors T2 entspricht, je hochohmiger der Widerstand R3 gewählt wird.

Besondere Vorteile ergeben sich durch Anordnen von Transistor T1 und Transistor T2 auf dem gleichen Chip, da eine gute Paarung sowie gute thermische Kopplung erreichbar sind. Dies ist mit der gestrichelten Linie in Figur 1 um Leistungsverstärker PA und Referenzstufe REF angedeutet.

In Abwandlungen der vorliegenden, beispielhaften Schaltungsanordnung könnte die Referenzspannung UREF auch in einer Referenzschaltung generiert werden, bei der der Widerstand R3 durch eine Konstantstromquelle ersetzt ist. Außerdem könnte der Strom, statt an der Source-Seite auch an der Drain-Seite unter Verwendung weiterer Regelverstärker eingeprägt werden. Der in der Referenzstufe fließende Strom muß nicht notwendigerweise sehr klein sein, da auch bei höheren Strömen noch eine gute Korrelation der Referenzspannung UREF mit der Schwellenspannung besteht.

In Abwandlungen des Ausführungsbeispiels kann statt der Verwendung eines Spannungssignals UREF zur Referenzierung auch ein Strom als Referenzgröße verwendet werden, in dem beispielsweise der Referenzwiderstand R3 selbst Teil des invertierenden Teils des Operationsverstärkers OP zur Erzeugung eines Ruhesignals wird.

In weiteren Abwandlungen des vorliegenden Ausführungsbeispiels könnten die Transistoren T1, T2 auch Bipolar-Transistoren sein. In diesem Fall könnte sich die Kompensation herstellungsbedingter Toleranzen auf die Gleichstrom-Verstärkung B beziehungsweise die Kleinsignal-Verstärkung β beziehen.

Bei Verwendung von HBT-Technologie könnte mit dem beschriebenen Prinzip die der Schwellenspannung entsprechende Einsatzspannung der Transistoren kompensiert werden.

## Patentansprüche

1. Verstärkerschaltung, welche umfaßt:
- einen Leistungsverstärker (PA) mit einem ersten Transistor (T1), dem eine Versorgungsspannung (V_{CC}) zuführbar ist, dem an seinem Steuereingang ein Eingangssignal (E) zuführbar ist, und an dessen erstem Lastanschluß ein Ausgangssignal (A) ableitbar ist,
- einen Regelverstärker (CU) mit einem Operationsverstärker (OP), dessen Ausgang mit dem Steuereingang des ersten Transistors (T1) verbunden ist, und dessen erster Eingang (OP1) mittels eines an den ersten Lastanschluß des ersten Transistors angeschlossenen Kondensators mit dem ersten Lastanschluß des ersten Transistors (T1) verbunden ist, und
- eine Referenzstufe (REF) mit einem zweiten Transistor (T2), dem die Versorgungsspannung (V_{CC}) zuführbar ist, und der an den Operationsverstärker (OP) angeschlossen ist, so daß diesem eine Referenzspannung (UREF) zuführbar ist, wobei das Eingangssignal (E) mittels eines an den Steuereingang des ersten Transistors (T1) angeschlossenen Kondensators (C1) zuführbar und das Ausgangssignal (A) mittels des an den ersten Lastanschluß des ersten Transistors (T1) angeschlossenen Kondensators (C2) ableitbar ist.

2. Verstärkerschaltung nach Anspruch 1,
**dadurch gekennzeichnet, daß**
erster und zweiter Transistor (T1, T2) auf dem gleichen Chip angeordnet sind.

3. Verstärkerschaltung nach Anspruch 1 oder 2,
**dadurch gekennzeichnet, daß**
ein Kondensator (C3) zwischen Ausgang und zweitem Eingang (OP2) des Operationsverstärkers (OP) geschaltet ist.

4. Verstärkerschaltung nach einem der Ansprüche 1 bis 3,
**dadurch gekennzeichnet, daß**
der erste und zweite Transistor (T1, T2) Feldeffekt-Transistoren gleichen Typs sind.

5. Verstärkerschaltung nach Anspruch 4,
**dadurch gekennzeichnet, daß**
der erste und der zweite Transistor (T1, T2) gleiche Steilheit und gleiche Schwellenspannung U_{TO} aufweisen.

6. Verstärkerschaltung nach Anspruch 5,
**dadurch gekennzeichnet, daß** der Referenz-Widerstand (R3) hochohmig ist.

7. Verstärkerschaltung nach einem der Ansprüche 1 bis 3,
**dadurch gekennzeichnet, daß**
der erste und der zweite Transistor (T1, T2) Bipolar-Transistoren gleichen Typs sind.

8. Verstärkerschaltung nach Anspruch 7,
**dadurch gekennzeichnet, daß**
der erste und zweite Transistor (T1, T2) gleiche statische Stromverstärkung und gleiche differentielle Stromverstärkung haben.

## Claims

1. Amplifier circuit which comprises:
- a power amplifier (PA) having a first transistor (T1) to which a supply voltage (V_{CC}) can be supplied, to whose control input an input signal (E) can be supplied, and at whose first load connection an output signal (A) can be tapped off,
- a control amplifier (CU) having an operational amplifier (OP), whose output is connected to the control input of the first transistor (T1), and whose first input (OP1) is connected to the first load connection of the first transistor (T1) by means of a capacitor which is connected to the first load connection of the first transistor, and
- a reference stage (REF) having a second transistor (T2), to which the supply voltage (V_{CC}) can be supplied, and which is connected to the operational amplifier (OP) so that a reference voltage (UREF) can be supplied to the operational amplifier (OP), the input signal (E) being able to be supplied by means of a capacitor (C1) which is connected to the control input of the first transistor (T1), and the output signal (A) being able to be tapped off by means of the capacitor (C2) which is connected to the first load connection of the first transistor (T1).

2. Amplifier circuit according to claim 1,
**characterized in that**,
the first and second transistors (T1, T2) are arranged on the same chip.

3. Amplifier circuit according to claim 1 or 2,
**characterized in that**,
a capacitor (C3) is connected between the output and the second input (OP2) of the operational amplifier (OP).

4. Amplifier circuit according to one of claims 1 to 3,
**characterized in that**,
the first and second transistors (T1, T2) are field-effect transistors of the same type.

5. Amplifier circuit according to claim 4,
**characterized in that**,
the first and second transistors (T1, T2) have the same gradient and the same threshold voltage U_{TO}.

6. Amplifier circuit according to claim 5,
**characterized in that**,
the reference resistor (R3) has a high resistance.

7. Amplifier circuit according to one of claims 1 to 3,
**characterized in that**,
the first and second transistors (T1, T2) are bipolar transistors of the same type.

8. Amplifier circuit according to claim 7,
**characterized in that**,
the first and second transistors (T1, T2) have the same static current gain and the same differential current gain.

## Revendications

1. Circuit amplificateur qui comprend :
- un amplificateur (PA) de puissance ayant un premier transistor (T1), auquel peut être appliqué une tension (V_{CC}) d'alimentation, à l'entrée de commande duquel peut être envoyé un signal (E) d'entrée et de la première borne de charge duquel peut être prélevé un signal (A) de sortie,
- un amplificateur (CU) de régulation ayant un amplificateur (OP) opérationnelle, dont la sortie est reliée à l'entrée de commande du premier transistor (T1) et dont la première entrée (OP1) est relié au moyen d'un condensateur raccordé à la première borne de charge du premier transistor (T1) et
- un étage (REF) de référence ayant un deuxième transistor (T2), auquel peut être appliquée la tension (V_{CC}) d'alimentation et qui est raccordé à un amplificateur (OP) opérationnel de manière à pouvoir appliquer à celui-ci une tension (UREF) de référence, le signal (E) d'entrée pouvant être envoyé au moyen d'un condensateur (C1) raccordé à l'entrée de commande du premier transistor (T1) et le signal (A) de sortie pouvant être prélevé au moyen du condensateur (C2) raccordé à la première borne de charge du premier transistor (T1).

2. Circuit amplificateur suivant la revendication 1,
**caractérisé**
**en ce que** le premier et le deuxième transistor (T1, T2) sont sur la même puce.

3. Circuit amplificateur suivant la revendication 1 ou 2,
**caractérisé**
**en ce qu'**un condensateur (C3) est monté entre la sortie et la deuxième entrée (P02) de l'amplificateur (OP) opérationnel.

4. Circuit amplificateur suivant l'une des revendications 1 à 3,
**caractérisé**
**en ce que** premier et le deuxième transistor (T1, T2) sont des transistors à effet de champ de même type.

5. Circuit amplificateur suivant la revendication 4,
**caractérisé**
**en ce que** le premier et le deuxième transistor (T1, T2) ont la même pente et la même tension (U_{TO}) de seuil.

6. Circuit amplificateur suivant la revendication 5,
**caractérisé**
**en ce que** la résistance (R3) de référence est à grande valeur ohmique.

7. Circuit amplificateur suivant l'une des revendications 1 à 3,
**caractérisé**
**en ce que** le premier et le deuxième transistor (T1, T2) sont des transistors bipolaires de même type.

8. Circuit amplificateur suivant la revendication 7,
**caractérisé**
**en ce que** le premier et le deuxième transistor (T1, T2) ont une même amplification statique du courant et une même amplification différentielle du courant.
